**Europäisches Patentamt**

**European Patent Office**

**Office européen des brevets**

(19)

(11) Numéro de publication: **0 030 499**

**B1**

(12)

# FASCICULE DE BREVET EUROPEEN

(45) Date de publication du fascicule du brevet: **08.08.84**

(51) Int. Cl.³: **H 01 L 35/08 //H01L35/20**

(21) Numéro de dépôt: **80401717.6**

(22) Date de dépôt: **01.12.80**

(54) **Dispositif sensible à un flux calorifique ou à un gradient de température et ensemble comprenant de tels dispositifs.**

(30) Priorité: **03.12.79 FR 7929699**

(43) Date de publication de la demande:
**17.06.81 Bulletin 81/24**

(45) Mention de la délivrance du brevet:
**08.08.84 Bulletin 84/32**

(84) Etats contractants désignés:
**AT BE CH DE FR GB IT LI LU NL SE**

(56) Documents cités:
**EP - A - 0 003 271**
**DE - A - 1 539 290**
**FR - A - 2 199 429**
**FR - A - 2 262 425**
**FR - A - 2 320 637**
**US - A - 3 607 445**

JOURNAL OF PHYSICS E: SCIENTIFIC
INSTRUMENTS, vol. 13, août 1980, Londres GB
P. THERY et al.: "Etude et caractérisation d'un
nouveau fluxmetre calorifique", pages 860-865

McGRAW-HILL ENCYCLOPEDIA, p. 584-585 et
600-607

Dictionnaire de l'électronique

(73) Titulaire: **ANVAR Agence Nationale de
Valorisation de la Recherche
43, rue Caumartin
F-75436 Paris Cédex 09 (FR)**

(72) Inventeur: **Thery, Pierre
45, rue de Lille
F-59650 Villeneuve d'Ascq (FR)**
Inventeur: **Ravalitera, Guy
2/1, Résidence du Mt. Liebaut rue Coty
F-62400 Bethune (FR)**
Inventeur: **Cornet, Michel
I.U.T., rue du Moulin à Tabac
F-62408 Bethune (FR)**

(74) Mandataire: **Lecca, Jean et al,
CABINET PLASSERAUD 84, rue d'Amsterdam
F-75009 Paris (FR)**

**0 030 499**

## Description

La présente invention concerne un dispositif, du type thermocouple, sensible à un flux calorifique ou à un gradient de température, c'est-à-dire un fluxmètre thermique ou capteur thermique et un ensemble comprenant une paire de tels dispositifs.

On connaît des couples thermo-électriques sensibles à un gradient de température, utilisables comme détecteurs de flux de chaleur, ou fluxmètres, comportant un ensemble de plaques minces de constantan, de cuivre et de chromel.

De tels fluxmètres sont décrits par exemple dans les brevets des Etats-Unis no. 3.607.445 et 3.767.470 au nom de Frank F. HINES.

On connaît par ailleurs des fluxmètres comportant une mince plaque allongée en matière plastique autour de laquelle est enroulé un fil de constantan dont une partie est argentée ou cuivrée, les portions argentées ou cuivrées constituant vraisemblablement des thermocouples, tandis que les parties non revêtues constituent des connections qui relient en série les thermocouples (voir livre de Max Jakob Heat Transfer, ed. John Wiley New York et Chapmann & Hall Londres 1957, vol. II, p. 195 et 196 où est décrit un dispositif imaginé par L.M.K. Boelter avec référence à la figure 33—23, ainsi qu'un prospectus non daté TPD, Technisch Physische Dienst de Delft, Pays-Bas).

La demanderesse vient de découvrir qu'il était possible de réaliser des fluxmètres en recouvrant une couche mince en constantan par un dépôt électrolytique de cuivre, plus généralement en recouvrant une couche mince d'un conducteur (ou d'un semi-conducteur) de l'électricité par un dépôt électrolytique d'un autre conducteur (ou semi-conducteur) de l'électricité, ces deux conducteurs (ou semi-conducteurs) ayant des pouvoirs thermoélectriques différents. On peut ainsi, à la place du couple constantan-cuivre, utiliser un couple semi-conducteur cuivre (le cuivre étant déposé électrolytiquement sur le semi-conducteur et dans les deux cas remplacer le cuivre par de l'argent.

La demanderesse a en effet constaté que, lorsqu' une couche conductrice ou semi-conductrice est revêtue d'un dépôt électrolytique conducteur ou semi-conducteur de matière différente, des courants électriques induits circulent à travers la surface qui sépare les deux conducteurs ou semi-conducteurs superposés, la circulation de ces courants provoquant, dans chacun des conducteurs ou semi-conducteurs, des chutes ohmiques qui sont proportionnelles à la moyenne spatiale du gradient thermique superficiel.

Cette propriété des dépôts électrolytiques sur une couche conductrice ou semi-conductrice est mise en oeuvre, dans le cadre de l'invention, pour réaliser un fluxmètre apte à mesurer un flux calorifique ou à commander des moyens de régulation, ou bien un capteur apte à engendrer de l'énergie électrique en réponse à un flux calorifique.

Pour réaliser des dispositifs de détection sensibles ou des capteurs aptes à débiter une puissance électrique non négligeable, on groupe une batterie de cellules élémentaires constituées chacune par une couche mince en un premier matériau conducteur ou semi-conducteur, revêtue par un dépôt électrolytique en un second matériau conducteur ou semi-conducteur.

Contrairement à la pratique antérieure consistant à réaliser des dispositifs du genre fluxmètre calorifique qui comportent une paroi auxiliaire isolante, de part et d'autre de laquelle sont disposés des thermocouples classiques constitués par exemple, comme indiqué précédemment, par des plaques minces de constantan, de cuivre et de chromel, l'invention consiste à réaliser un dispositif selon la revendication 1, sensible à un gradient de température, applicable pour mesurer un flux calorifique ou pour transformer un tel flux en un courant électrique disponible.

Comme on le précisera ci-après, lorsqu'on met en oeuvre une cellule unique constituée par une couche mince en un premier matériau conducteur ou semi-conducteur, revêtue par un dépôt électrolytique en un second matériau conducteur ou semi-conducteur, les propriétés thermo-électriques du premier et du second matériau étant différentes, un gradient thermique parallèle à la surface de contact entre les deux matériau engendre un courant électrique circulant à travers la cellule. Pour mesurer un gradient thermique perpendiculaire à cette surface, c'est-à-dire un flux thermique traversant cette surface, il est nécessaire de prévoir une certaine dissymétrie relative entre la couche mince et le dépôt électrolytique, les surfaces en regard du dépôt et de la couche ne coïncidant pas complètement afin de créer un gradient de chaleur parallèle à la surface de contact entre les deux matériaux et se ramener donc au cas précédent.

De préférence le premier matériau est en l'alliage appelé constantan (conducteur) ou bien un semi-conducteur, tandis que le second matériau est du cuivre ou de l'argent (conducteur).

Avantageusement le dispositif selon l'invention comprend de nombreuses cellules du type précité de petite dimension groupées conformément au dispositif de la revendication 1.

On peut ainsi réaliser un fluxmètre comportant au moins un millier de cellules élémentaires disposées sur un substrat.

On peut également réaliser un ensemble sensible à un flux calorifique ou à un gradient de températures comportant plusieurs milliers de cellules constituées en particulier par deux rangées de pièces en constantan cuivré ou argenté, ces deux rangées étant séparées par des couches alternées de cuivre ou argent et de constantan, l'ensemble engendrant un courant électrique lorsque les deux rangées précitées sont traversées en série par un flux de chaleur, conformément à la revendication 8.

2

# 0 030 499

L'invention pourra, de toute façon, être bien comprise à l'aide du complément de description qui suit, ainsi que des dessins ci-annexés, lesquels complément et dessins sont, bien entendu, donnés surtout à titre d'indication.

La figure 1 illustre, en coupe, une cellule élémentaire d'un dispositif selon l'invention et sensible à un gradient de température ou flux calorifique.

La figure 2 représente, également en coupe, un ensemble de deux dispositifs comportant plusieurs cellules élémentaires selon la figure 1.

Les figures 3 à 5 représentent, vus en plan, deux modes de réalisation particuliers d'un dispositif selon l'invention, les figures 4 et 5 illustrant à plus grande échelle des portions de la figure 3 dans le cas des deux modes de réalisation.

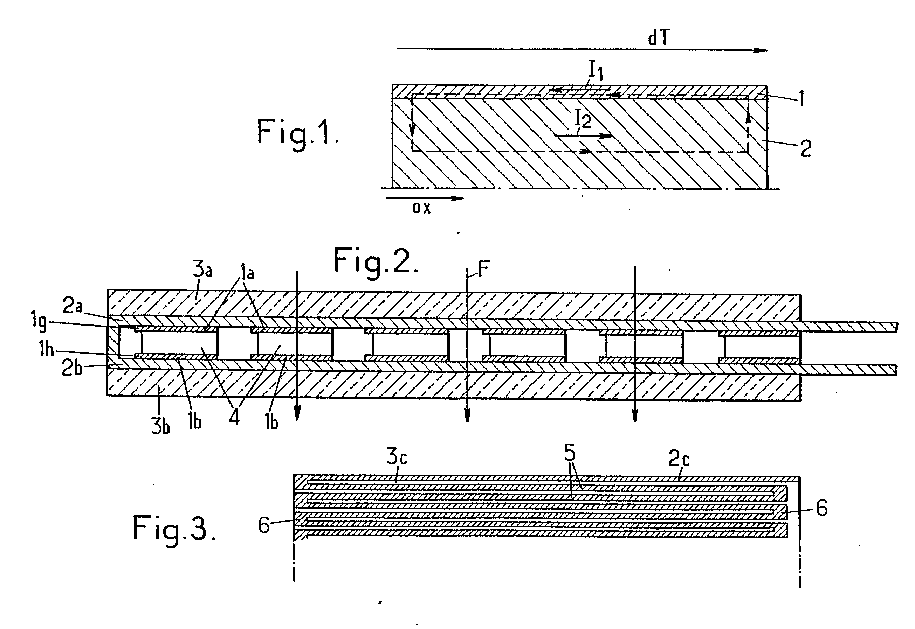

On se réfère tout d'abord à la figure 1 sur laquelle on a illustré schématiquement une cellule élémentaire appliquant l'idée générale de l'invention, à savoir la réalisation d'un élément sensible à un flux de chaleur constitué par une couche mince d'un premier conducteur ou semi-conducteur, revêtue d'un très mince dépôt électrolytique en un second conducteur ou semi-conducteur.

Sur la figure 1, on a représenté en 2 ladite couche mince, réalisée par exemple en l'alliage de cuivre et de nickel appelé constantan, et en 1 le très mince dépôt électrolytique réalisé par exemple en cuivre.

En présence d'une différence de température tangentielle dT, des courants électriques induits $I_1$ (dans le dépôt 1 de cuivre) et $I_2$ (dans la couche 2 de constantan) de sens opposés prennent naissance. Il se forme ainsi des courants circulant à travers la surface de séparation entre les deux conducteurs (ou semi-conducteurs) 1 et 2 (circuit des courants électriques représenté en traits interrompus). L'intensité des courants électriques ainsi produits par la différence dT est proportionnelle à dT, ce qui permet de réaliser, avec l'élément sensible de la figure 1, la mesure d'un gradient thermique ou flux calorifique; il suffit en effet de déterminer l'intensité des courants induits par ce gradient dans l'élément de la figure 1.

Plusieurs cellules (par exemple un millier de cellules) selon la figure 1 peuvent être disposées sur un substrat sur la même bande continue du premier matériau.

L'étude théorique et experimentale de l'effet thermoélectrique dans les systèmes constitués par une couche conductrice recouverte d'un dépôt électrolytique a permis de mettre en évidence des propriétés particulièrement intéressantes. Sous l'action d'un gradient thermique superficiel, il y a apparition, dans chacune des couches conductrices superposées, de courants induits circulant à travers la surface de séparation des conducteurs superposés. L'intensité de ces courants est proportionnelle à la valeur instantanée de la moyenne spatiale du gradient thermique superficiel. Les chutes ohmiques provoquées par le passage de ces courants sont des informations représentatives des échanges calorifiques superficiels.

a) Résultats expérimentaux

Les dispositifs étudiés ont été réalisés en déposant par voie électrolytique une couche de cuivre d'épaisseur voisine de un micron sur une feuille de constantan d'épaisseur voisine de vingt-cinq microns. Lorsque la surface du système schématisé figure 1 est soumise à un gradient thermique tangentiel suivant la direction ox, chacun des conducteurs superposés 1 et 2 est soumis à une tension électrique $V_1$ et $V_2$ respectivement. Ces tensions électriques $V_1$ et $V_2$ ont été mesurées en connectant un microvoltmètre dan des circuits constitués avec des fils de cuivre et de constantan respectivement de façon à éliminer les forces électromotrices classiques d'origines thermoélectriques. La valeur des tensions $V_1$ et $V_2$ ne dépend pas uniquement de la différence de température entre les extrémités du dépôt électrolytique, mais de la symétrie du champ de température superficielle par rapport au plan passant par le milieu du système. Lorsque la distribution de température superficielle est symétrique: $T(x) = T(-x)$, les tensions observées sont identiquement nulles: $V_1 = V_2 = 0$. Par contre, lorsque $T(x) \neq T(-x)$, les tensions $V_1$ et $V_2$ ont des valeurs non nulles. L'amplitude de ces tensions dépend du degré de dissymétrie du champ de températures superficielles imposé. Cet effet thermoélectrique particulier a été caractérisé en appliquant une distribution antisymétrique uniforme définie par la relation

$$T(x) = T_o + \Delta T(x) \qquad T(-x) = T_o - \Delta T(x)$$

$$\text{avec} \quad \frac{\partial T}{\partial x} = \frac{T_1 - T_2}{l} \quad \text{si} \quad -\frac{l}{2} < x < \frac{l}{2}$$

L'amplitude du gradient thermique imposé est déterminée par la difference de température $T_2 - T_1$ appliquée entre les extrémités du dépôt électrolytique de dimension l. Les résultats expérimentaux ont montré que $V_1$ et $V_2$ sont proportionnelles au gradient de température. Les tensions $V_1$ et $V_2$ ont été comparées aux tensions $V_1'$ et $V_2'$ qui apparaissent dans le même dispositif non cuivré (thermocouple habituel).

Ces tensions sont liées par la relation

3

**0 030 499**

$$V_1 - V_2 = V_1' \qquad V_2' = 0 \qquad\qquad (1)$$

quelle que soit la valeur de $T_2 - T_1$.

Le rapport $V_1/V_2$ dépend du rapport des épaisseurs des dépôts de cuivre et de constantan.

L'observation $V_2' = 0$ est conforme à la loi bien connue selon laquelle il ne peut y avoir apparition de tension par effet thermoélectrique dans un conducteur homogène soumis à une différence de température. Lorsque le constantan est cuivré, il y a apparition dans le circuit constantan d'une tension $V_2$ proportionnelle à la différence de température entre les extrémités de la région cuivrée. La relation (1) a été vérifiée quelle que soit l'épaisseur du cuivrage et sera utilisée pour justifier l'interprétation théorique ci-après.

La relation de proportionnalité entre $V_1$ et $V_2$ et la différence de température appliquée n'est vérifiée que si le gradient thermique superficiel appliqué est uniforme. L'étude des tensions $V_1$ et $V_2$ induites lorsque le profil de température n'est pas uniforme a permis de montrer que les informations électriques $V_1$ et $V_2$ étaient proportionnelles à la moyenne spatiale instantanée du gradient thermique tangentiel.

Lorsque le constantan n'est pas entièrement cuivré les tensions induites sont proportionnelles à la moyenne spatiale instantanée du gradient thermique dans les régions cuivrées.

b) Interprétation de l'effet thermoélectrique superficiel.

Les équations phénoménologiques permettant de représenter le couplage thermoélectrique dans un conducteur homogène sont bien connues (Landau). Elles s'appliquent dans chacun des conducteurs superposés constituant le système étudié. Les densités de courant $j_1$ et $j_2$ induits suivant ox, dans chacun conducteurs notés 1 et 2, par un gradient thermique superficiel

$$\frac{\partial T}{\partial x}$$

appliqué suivant la direction ox et représenté par la composante tangentielle

$$\frac{\partial T}{\partial x}$$

sont de la forme

$$\left\{ \begin{array}{l} j_1 = \sigma_1 E_1 - \alpha_1 \sigma_1 \dfrac{\partial T}{\partial x} \\[2em] j_2 = \sigma_2 E_2 - \alpha_2 \sigma_2 \dfrac{\partial T}{\partial x} \end{array} \right.$$

$\sigma_1$ et $\sigma_2$ désignant les conductivités superficielles des conducteurs 1 et 2 et $\alpha_1$ et $\alpha_2$ étant des coefficients relatifs à ces conducteurs 1 et 2.

L'épaisseur des conducteurs 1 et 2 étant faible vis-à-vis de leurs dimensions latérales, les variations de température dans le sens de l'épaisseur peuvent être négligées et l'étude peut être limitée au couplage thermoélectrique tangentiel dans la direction ox. Les intensités électriques induites $I_1$ et $I_2$ par unité de longueur dans la direction perpendiculaire à ox sont:

$$I_1 = e_1 j_1 \qquad I_2 = e_2 j_2$$

$$I_1 = \sigma_1 e_1 E_1 - \alpha_1 \sigma_1 e_1 \frac{\partial t}{\partial x}$$

$$\qquad\qquad\qquad\qquad (2)$$

$$I_2 = \sigma_2 e_2 E_2 - \alpha_1 \sigma_2 e_2 \frac{\partial T}{\partial x}$$

En circuit ouvert, les intensités $I_1$ et $I_2$ sont liées par la relation $I_1 + I_2 = 0$.

D'autre part, sur la surface de séparation des conducteurs 1 et 2, il y a conservation de la composante tangentielle du champ électrique: $E_1 = ED_2 = E$.

Les champs électromoteurs d'origine thermoélectrique

## 0 030 499

$$\alpha_1 \frac{\partial t}{\partial_x} \quad et \quad \alpha_2 \frac{\partial T}{\partial x}$$

ayant des valeurs différentes, la conservation de la composante tangentielle du chanp électrique ne peut être réalisée que si les courants $I_1$ et $I_2$ ont des valeurs différentes de zéro. L'application des conditions limites permet de calculer les valeurs du champ électrique et des courants $I_1$ et $I_2$ en chaque point du système:

$$E = \frac{(\alpha_1 \sigma_1 e_1 + \alpha_2 \sigma_2 e_2)}{\sigma_1 e_1 + \sigma_2 e_2} \left(\frac{\partial T}{\partial x}\right)$$

$$I_1 = -I_2 = \frac{(\alpha_2 - \alpha_1)\sigma_1 \sigma_2 e_1 e_2}{(\sigma_1 e_1 + \sigma_2 e_2)} \left(\frac{\partial T}{\partial x}\right) \tag{3}$$

Le couplage thermoélectrique est matérialisé par une distribution de courants électriques localisés aux endroits où le gradient thermique tangentiel a une valeur non nulle. Ces courants induits par l'inégalité des champs thermoélectriques dans les milieux conducteurs se referment à travers la surface de séparation (figure 1). Les valeurs de $I_1$ et $I_2$ sont telles que les chutes ohmiques induites par le passage de ces courants dans les conducteurs compensent le déséquilibre électrique dû à l'intégalité des champs thermoélectriques. Il est en effet facile de vérifier que:

$$\alpha_1 \frac{\partial T}{\partial x} + \frac{I_1}{\sigma_1 e_1} = \alpha_2 \frac{\partial T}{\partial x} + \frac{I_2}{\sigma_2 e_2}$$

Le passage de ces courants provoque des chutes ohmiques dans les conducteurs superposés. Les tensions élémentaires $dV_1$ et $dV_2$ induites dans une tranche de longueur dx dans chacun des conducteurs ont pour valeur:

$$\left\{ \begin{array}{l} dV_1 = \dfrac{I_1}{\sigma_1 e_1} dx = I_1 dR_1 = \dfrac{(\alpha_2 - \alpha_1)\sigma_2 e_2}{\sigma_1 e_1 + \sigma_2 e_2} \left(\dfrac{\partial T}{\partial x}\right) dx \\[4mm] dV_2 = \dfrac{I_2 dx}{\sigma_2 e_2} = I_2 dR_2 = \dfrac{(\alpha_1 - \alpha_2)\sigma_1 e_1}{(\sigma_1 e_1 + \sigma_2 e_2)} \left(\dfrac{\partial T}{\partial x}\right) dx \end{array} \right. \tag{4}$$

$dR_1$ et $dR_2$ étant la résistance de la tranche de longueur dx dans les conducteurs 1 et 2.

Ces tensions élémentaires sont de signes opposés et d'amplitudes inégales. Leur somme arithmétique vérifie localement la relation:

$$dV_1 - dV_2 = (\alpha_2 - \alpha_1) \frac{\partial T}{\partial x} dx$$

Pour interpréter les résultats expérimentaux, il faut calculer la valeur globale des tensions $V_1$ et $V_2$. Ces tensions, représentant des chutes ohmiques, sont liées aux moyennes spatiales des courants $I_1$ et $I_2$. La somme des courants induits en chaque point du dispositif étant identiquement nulle puisque $I_1 = -I_2$; il en est de même du courant global dans l'ensemble du système.

Par contre, les moyennes spatiales $\overline{I}_1$ et $\overline{I}_2$ sont différentes de zéro; elles sont liées à la moyenne spatiale du gradient thermique par la relation:

$$\overline{I}_1 = -\overline{I}_2 = \frac{(\alpha_2 - \alpha_1)\sigma_1 \sigma_2 e_1 e_2}{(\sigma_1 e_1 + \sigma_2 e_2)} \left(\overline{\frac{\partial T}{\partial x}}\right)$$

A ces courants de valeurs moyennes non nulles sont associées des chutes ohmiques liées à la moyenne spatiale du gradient thermique par les relations:

5

$$\left\{ \begin{array}{l} \overline{V}_1 = R_1\overline{I}_1 = \dfrac{(\alpha_2 - \alpha_1)\sigma_2 e_2 \cdot I}{(\sigma_1 e_1 + \sigma_2 e_2)} \, (\dfrac{\overline{\partial T}}{\partial x}) \\[4mm] \overline{V}_1 = R_2\overline{I}_2 = \dfrac{(\alpha_1 - \alpha_2)\sigma_1 e_1 I}{(\sigma_1 e_1 + \sigma_2 e_2)} \cdot (\dfrac{\overline{\partial T}}{\partial x}) \end{array} \right. \qquad (5)$$

I étant la longueur du domaine recouvert par le dépôt électrolytique. Les tensions $\overline{V}_1$ et $\overline{V}_2$ induites dans les conducteurs sont de valeurs inégales; elles dépendent de la valeur moyenne instantanée du gradient thermique tangentiel et non de la valeur instantanée de la différence de température entre les contacts thermoélectriques.

Dans le cas plus général où la direction suivant laquelle on mesure les tensions électriques n'est pas parallèle à la direction suivant laquelle est appliquée la contrainte thermique, les expressions précédentes sont encore valables à condition de remplacer

$$(\dfrac{\overline{\partial T}}{\partial x}) \quad \text{par} \quad \dfrac{\overline{\partial T}}{\partial x}$$

cos $\Phi$, $\Phi$ étant l'angle entre les deux directions.

L'effet thermoélectrique induit dans un conducteur recouvert d'un dépôt électrolytique est différent de l'effet thermoélectrique habituellement mis en oeuvre. En particulier, il peut y avoir production d'une tension électrique dans une couche, dont les extrémités sont isothermes, soumise à une sollicitation thermique spatialement dissymétrique.

Les tensions observées expérimentalement peuvent être identifiées aux chutes ohmiques $\overline{V}_1$ et $\overline{V}_2$ puisque les forces électromotrices d'origine thermoélectrique ne sont pas observables dans un conducteur homogène fermé. Lorsque la distribution de température est symétrique:

$$\dfrac{\partial T}{\partial x}(x) = - \dfrac{\partial T}{\partial x}(-x) \quad \text{il en résulte} \quad \dfrac{\overline{\partial T}}{\partial x} = 0 \quad \text{et} \quad \overline{V}_1 = \overline{V}_2 = 0$$

Ce résultat correspond aux observations expérimentales.

Lorsque le système est soumis à une distribution de température dissymétrique caractérisée par une valeur uniforme du gradient thermique

$$(\dfrac{\overline{\partial T}}{\partial x}) = \dfrac{(T_2 - T_1)}{I}$$

les tensions induites sont définies par les relations:

$$\overline{V}_1 = \dfrac{(\alpha_2 - \alpha_1)\sigma_2 e_2}{(\sigma_1 e_1 + \sigma_2 e_2)} (T_2 - T_1)$$

$$(6)$$

$$\overline{V}_2 = \dfrac{(\alpha_1 = \alpha_2)\sigma_1 e_1}{(\sigma_1 e_1 + \sigma_2 e_2)} (T_2 - T_1)$$

Ces tensions sont de valeurs différentes et ont pour somme arithmétique:

$$\overline{V}_1 - \overline{V}_2 = (\alpha_1 - \alpha_1)(T_2 - T_1)$$

Cette relation a été vérifiée expérimentalement et justifie l'interprétation ci-dessus. Dans ce cas particulier, la somme algébrique $V_1 - V_2$ est proportionnelle à la différence de température $T_2 - T_1$ aux bornes de la métallisation. Le coefficient de proportionnalité est celui d'un thermocouple classique. Les valeurs individuelles des tensions $\overline{V}_1$ et $\overline{V}_2$ induites dans les conducteurs dépendent des valeurs relatives des quantités $\sigma_1 e_1$ et $\sigma_2 e_2$. Lorsque la tension est mesurée dans le conducteur métallisé (noté 1), il est souhaitable de réaliser la condition $\sigma_2 e_2 > \sigma_1 e_1$ afin d'obtenir une sensibilité voisine de celle d'un thermocouple classique.

c) Coefficient de conductivité thermique du système.

Pour caractériser totalement cet effet thermoélectrique particulier, les tensions $\overline{V}_1$ et $\overline{V}_2$ doivent être reliées aux flux calorifiques $\Phi_1$ et $\Phi_2$ localisés dans chacun des conducteurs superposés. L'expression générale de la densité de flux calorifique dans un conducteur homogène parcouru par un courant de densité j et soumis au gradient thermique

$$\frac{\partial T}{\partial x} \quad \text{est de la forme} \quad \Phi = \alpha Tj - \lambda \frac{\partial T}{\partial x} \tag{7}$$

Connaissant les expressions (3) définissant les courants électriques dans chacun des conducteurs, la relation (7) permet de calculer les flux $\Phi_1$ et $\Phi_2$ dans chacun des conducteurs.

$$\Phi_1 = \left[ -\lambda_1 e_1 + \frac{\alpha_1(\alpha_2 - \alpha_1)\sigma_1\sigma_2 e_1 e_2 T}{(\sigma_1 e_1 + \sigma_2 e_2)} \right] \frac{\partial T}{\partial x} \tag{8—1}$$

$$\Phi_2 = \left[ -\lambda_2 e_2 + \frac{\alpha_2(\alpha_1 - \alpha_2)\sigma_1\sigma_2 e_1 e_2 T}{(\sigma_1 e_1 + \sigma_2 e_2)} \right] \frac{\partial T}{\partial x} \tag{8—2}$$

$$\Phi = \Phi_1 + \Phi_2 = - \left[ \lambda_1 e_1 + \lambda_2 e_2 + \frac{(\alpha_1 - \alpha_2)^2\sigma_1\sigma_2 e_1 e_2 T}{(\sigma_1 e_1 + \sigma_2 e_2)} \right] \frac{\partial T}{\partial x} \tag{8—3}$$

Les coefficients de proportionnalité entre flux et gradient thermique dépendent des coefficients thermoélectriques des conducteurs superposés. Il y a modification des conductivités thermiques par couplage thermoélectrique. La résistance thermique du système.

$$\lambda' = \lambda_1 e_1 + \lambda_2 e_2 + \frac{(\alpha_1 - \alpha_2)^2\sigma_1\sigma_2 e_1 e_2}{\sigma_1 e_1 + \sigma_2 e_2} \tag{9}$$

est augmentée par couplage thermoélectrique. Cette augmentation de la conductivité est due à la production d'un flux d'énergie électrique qui augmente l'efficacité des échanges énergétiques. Lorsque les variations de la température superficielle sont faibles vis-à-vis de la valeur de la température absolue, le flux calorifique $\Phi$ est proportionnel au gradient thermique

$$\frac{\partial T}{\partial x}.$$

Les tensions $\overline{V}_1$ et $\overline{V}_2$ sont donc proportionnelles à la moyenne spatiale du flux calorifique.

Au lieu d'être disposé tangentiellement par rapport au gradient thermique comme illustré sur la figure 1, un élément, ou cellule élémentaire, sensible selon l'invention, peut être disposé perpendiculairement au flux. Le flux et le gradient thermique à mesurer étant alors perpendiculaires à la surface du thermoélément, il est nécessaire de provoquer par construction une dissymétrie dans l'écoulement de la chaleur de façon à induire un gradient thermique sur la surface sensible du thermoélément.

Sur la figure 2 on a illustré un ensemble de tels éléments ou cellules destiné à accroître la sensibilité du fluxmètre.

Sur cette figure on a désigné par 3a et 3b deux plaques réalisées par exemple en une résine époxy transparente, le flux de chaleur traversant ces deux plaques dans le sens des flèches F.

Entre ces deux plaques 3a et 3b sont disposées deux plaques 2a et 2b en constantan revêtues sur des portions de leur longuer par des dépôts électrolytiques de cuivre, respectivement 1a et 1b; enfin des pièces 4 conductrices de la chaleur relient les dépôts 1a, 1b en assurant un contact thermique entre chaque paire de revêtement électrolytiques 1a, 1b disposés vis-à-vis.

On notera que les pièces 4 sont plus courtes (dans le sens perpendiculaire à celui des flèches F) que les dépôts électrolytiques 1a et 1b, ces dépôts débordant en 1g et 1h par rapport aux pièces 4, et on obtient ainsi, un courant électrique proportionnel au flux calorifique traversant le dispositif de la figure 2 dans le sens des flèches F, du fait du dépassement des portions 1g, 1h des couches 1a et 1b.

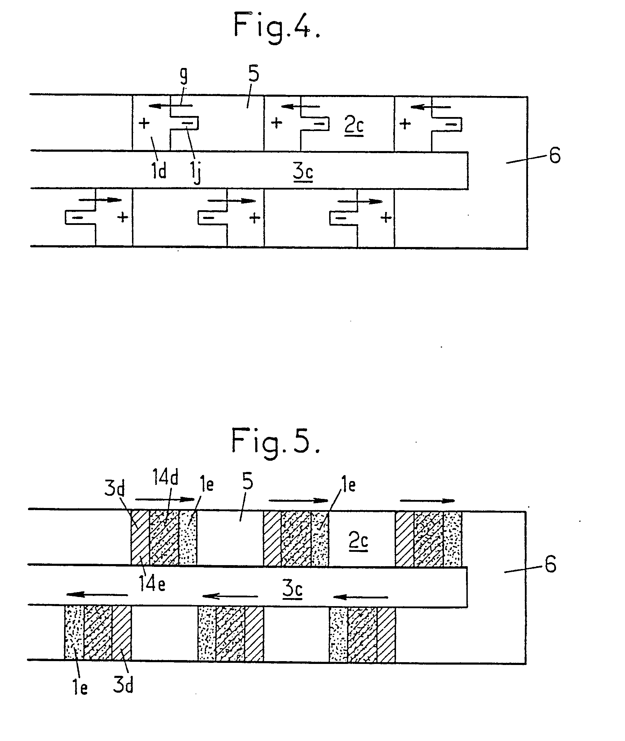

Sur les figures 3 à 5, on a illustré deux modes de réalisation d'un dispositif unitaire compact sensible à un flux de chaleur. Ce dispositif est constitué (figure 3) par une plaque 3c en un matériau plastique, sur laquelle on a déposé une couche mince méandriforme 2c en constantan. Cette couche 2c comporte une succession de bandes rectilignes étroites 5 connectés en série à leurs extrémités par des

7

ponts 6 également en l'alliage constantan. Sur cette couche 2c sont réalisés des dépôts électrolytiques en argent ou en cuivre. Deux formes de dépôts possibles assurant une dissymétrie sont illustrées sur les figures 4 et 5 à plus grande échelle que la figure 3 et sur lesquelles on retrouve une portion de la plaque 3c et de la couche méandriforme 2c.

Sur les figures 4 et 5 on a illustré deux formes géométriques différentes de dépôts électrolytiques.

Dans le cas de la figure 4 les dépôts électrolytiques 1d ont une forme dissymétrique avec une queue 1j. On a représenté sur la figure 4 les polarités (+ et −) et le sens (flèches g) du courant superficiel.

Dans le cas du mode de réalisation de la figure 5, les dépôts électrolytiques 1e sont de forme rectangulaire (ou carrée) et des revêtements de résine 3d sont réalisés pour chevaucher chacun une portion d'un dépôt électrolytique 1e (dans la zone 14d) et une portion adjacente de la couche mince de constantan 2c non revêtue de dépôt électrolytique (dans la zone 14e).

On voit que l'invention permet de réaliser un dispositif sensible à un gradient de température ou à un flux calorifique. Un tel dispositif peut être utilisable comme fluxmètre calorifique, appareil de mesure de différences de températures ou convertisseur d'énergie calorifique en énergie électrique.

Il se distingue des thermocouples classiques constantan/cuivre par le fait qu'il comporte un très mince dépôt électrolytique de cuivre sur une couche mince de constantan, ce qui permet de réaliser des dispositifs puissants très compacts.

Un dispositif selon l'invention permet de réaliser des régulations (en délivrant un signal de commande à un organe réglant le chauffage) par comptage des calories traversant une certaine surface.

Il permet également de déterminer le coefficient de déperdition thermique d'une paroi, notamment d'un mur.

Il permet également de mesurer les échanges de chaleur des êtres vivants avec leur environnement, en étant alors réalisé sous la forme d'une plaquette fluxmétrique fixable sur la peau d'un être vivant par exemple au moyen d'une pellicule autocollante sur ses deux faces.

Dans les modes de réalisation donnés à titre d'exemple, on s'est constamment référé à des dépôts électrolytiques de cuivre ou d'argent sur du constantan, mais l'invention s'applique également à d'autres dépôts électrolytiques très minces de conducteurs ou semi-conducteurs électriques sur des couches minces de conducteurs ou semi-conducteurs électriques de type différent, par exemple aux dépôts électrolytiques de cuivre ou d'un autre métal conducteur (tel que l'argent) sur un semi-conducteur.

## Revendications

1. Dispositif sensible à un flux calorifique ou à un gradient de température, comportant un premier et un second matériau conducteur ou semi-conducteur ayant des propriétés thermoélectriques différentes, le premier matériau constituant une couche mince continue en forme de bande allongée sensiblement plane appliquée sur la surface d'un support en matière isolante, le second matériau constituant une série de zones distinctes formées par des dépôts électrolytiques, plus minces que la couche en forme de bande, appliqués sur des zones successives de la couche mince le long de ladite bande sur la face de la couche mince qui n'est pas appliquée sur ladite surface du support en matière isolante, ledit dispositif comportant de plus des moyens impartissant une dissymétrie à chacun desdits dépôts dans la direction d'allongement de la bande, toujours dans le même sens suivant cette direction, ladite dissymetrie entraînant une différence de température entre les deux extrémités de chacun desdits dépôts dans la direction d'allongement de ladite bande lorsque ladite couche mince est placée sensiblement perpendiculairement à la direction d'un flux calorifique ou d'un gradient de température (F), de sorte qu' une force électromotrice soit engendrée lorsque ladite couche mince est placée sensiblement perpendiculairement à la direction dudit flux calorifique ou dudit gradient de température (F).

2. Dispositif selon la revendication 1, caractérisé en ce que lesdits moyens impartissant une dissymétrie sont constitués par une série de couches de résine (3d), chacune de ces couches recouvrant une partie (14d) de chacun desdits dépôts et une partie (14e) d'une portion de ladite couche mince adjacente non recouverte par un dépôt (figure 5).

3. Dispositif selon la revendication 2, caractérisé en ce que chaque dépôt (le) a la forme d'un rectangle disposé transversalement à la direction d'allongement de la bande et chaque zone (3d) de résine a également la forme d'un rectangle disposé transversalement à ladite direction d'allongement de la bande, chaque zone de résine étant disposée en partie sur un dépôt du second matériau et en partie sur la couche mince adjacente non revêtue du second matériau (figure 5).

4. Dispositif selon la revendication 1, caractérisé en ce que, pour constituer lesdits moyens impartissant une dissymétrie, chaque dépôt en second matiériau (1d) a une forme dissymétrique dans la direction d'allongement de la bande (figure 4).

5. Dispositif selon la revendication 4, caractérisé en ce que chaque dépôt en second matériau (1d) comporte une portion sensiblement rectangulaire disposée transversalement à la direction d'allongement de la bande et une queue (1j) dirigée dans la direction d'allongement de la bande, toujours dans le même sens (figure 4).

6. Dispositif selon l'une quelconque des revendications précédentes, caractérisé en ce que la bande allongée sensiblement plane est en forme bande continue méandriforme (2c).

7. Dispositif selon l'une quelconque des revendications précédentes, caractérisé en ce que le premier matériau est l'alliage appelé constantan, tandis que le second matériau est un métal conducteur pris dans le groupe constitué par le cuivre et l'argent.

8. Ensemble sensible à un flux calorifique ou à un gradient de température, comprenant une paire de dispositifs selon l'une quelconque des revendications précédentes, la couche mince du premier dispositif étant connectée électriquement en série avec la couche mince du second dispositif, les deux dispositifs comportant un même nombre de dépôts en second matériau, les deux dispositifs de la paire étant disposés face à face avec les dépôts (1a) du premier dispositif vis-à-vis des dépôts (1b) du second dispositif, de manière que, lorsque ledit ensemble est placé avec ses deux couches minces sensiblement perpendiculairement à la direction d'un flux calorifique ou d'un gradient de température, ledit flux calorifique ou gradient de température traverse, pour l'un des dispositifs, chaque dépôt après la couche mince, et, pour l'autre dispositif, avant la couche mince, et comprenant en outre un ensemble de blocs (4), en une matière conductrice de la chaleur, en nombre égal à celui des dépôts de chaque dispositif, chacun des ces blocs étant en contact par une de ses faces avec un dépôt (1a) du premier dispositif et par sa face opposée avec le dépôt (1b) vis-à-vis du second dispositif et ayant une dimension, dans la direction d'allongement de la bande de chaque dispositif, inférieure à la dimension, dans la même direction, des deux dépôts disposés vis-à-vis, avec lesquels il est en contact, de manière à laisser toujours d'un même premier côté pour le premier dispositif et toujours d'un même second côté, opposé au premier côté, pour le second dispositif dans la direction d'allongement des bandes des deux dispositifs, une portion (1g, 1h) de chaque dépôt (1a, 1b) qui n'est pas en contact avec ledit bloc (figure 2).

## Patentansprüche

1. Auf einen Wärmefluß oder ein Temperaturgefälle empfindlich reagierende Vorrichtung, bestehend aus einem ersten und einem zweiten leitenden oder halbleitenden Werkstoff mit unter-schiedlichen thermoelektrischen Eigenschaften, dadurch gekennzeichnet, daß der erste Werkstoff eine auf der Oberfläche eines Isolierwerkstoffs eben aufgebrachte dünne, kontinuierliche Schicht in Form eines länglichen Bandes bildet, daß der zweite Werkstoff eine Reihe durch elektrolytische Ablagerungen in Längsrichtung des Bandes, aus der nicht mit der Oberfläche des Isolierwerkstoffs verbundenen Oberfläche der dünnen Schicht gebildeter Zonen umfaßt, wobei die Zonen eine dünnere Schichtdicke aufweisen als das Band und daß die Vorrichtung einen durch jede der Ablagerungen hervorgerufenen sich in Längsrichtung des Bandes erstreckenden und in Längsrichtung wiederholenden asymmetrischen Aufbau aufweist, wobei die Asymmetrie eine Temperaturdifferenz zwischen den beiden Enden einer jeden Ablagerung in Richtung des Bandes zur Folge hat, wenn die dünne Schicht exakt senkrecht zur Richtung des Wärmestroms oder des Temperaturgefälles verläuft, so daß eine elektromotorische Kraft erzeugt wird, wenn die dünne Schicht senkrecht zur Richtung des Wärmeflusses oder des Temperaturgefälles verläuft.

2. Vorrichtung nach Anspruch 1, dadurch gekennzeichnet, daß der asymmetrische Aufbau durch eine Reihe von Schichten aus Harz (3d) hervorgerufen wird, von denen jede der Schichten einen Teil (14d) einer jeden Ablagerung bedeckt und ein Teil (14e) eines Abschnitts der dünnen angrenzenden Schicht von einer Ablagerung nicht bedeckt wird (Fig. 5).

3. Vorrichtung nach Anspruch 2, dadurch gekennzeichnet, daß jede Ablagerung (1e) die Form eines quer zur Längsrichtung des Bandes angeordneten Rechtecks aufweist und jede Harzzone (3d) auch die Form eines quer zur Längsrichtung des Bandes angeordneten Rechtecks aufweist, wobei jede Harzzone zum Teil auf einer Ablagerung des zweiten Werkstoffs und zum Teil auf der dünnen angrenzenden, nicht mit dem zweiten Werkstoff bedeckten Schicht angeordnet ist.

4. Vorrichtung nach Anspruch 1, dadurch gekennzeichnet, daß zur Bildung des asymmetrischen Aufbaus jede Ablagerung aus dem zweiten Werkstoff (1d) eine asymmetrische Form in Längsrichtung des Bandes aufweist (Fig. 4).

5. Vorrichtung nach Anspruch 4, dadurch gekennzeichnet, daß jede Ablagerung aus dem zweiten Werkstoff (1d) einen rechteckigen, quer zur Längsrichtung des Bandes angeordneten Teil und einen in Längsrichtung des Bandes ausgerichteten, immer in die gleiche Richtung weisenden Vorsprung (1j) aufweist.

6. Vorrichtung nach einem der vorhergehenden Ansprüche 1 bis 5, dadurch gekennzeichnet, daß das längliche, ebene Band die Form eines kontinuierlichen, mäanderförmigen Bandes aufweist.

7. Vorrichtung nach einem der Ansprüche 1 bis 6, dadurch gekennzeichnet, daß der erste Werkstoff die Legierung Konstantan ist, während der zweite Werkstoff ein leitendes Metall, beispielsweise Kupfer oder Silber, ist.

8. Die gesamte, auf einen Wärmestrom oder ein Temperaturgefälle empfindlich reagierende Anordnung ist gekennzeichnet durch ein Paar von Vorrichtungen nach einem der Ansprüche 1 bis 7, wobei die dünne Schicht der ersten Vorrichtung elektrisch in Reihe geschaltet ist mit der dünnen Schicht der zweiten Vorrichtung, die beiden Vorrichtungen die gleiche Anzahl von Ablagerungen des zweiten Werkstoffs aufweisen, und die zwei Vorrichtungen eines Paares so angeordnet sind, daß die Ablagerungen (1a) der ersten Vorrichtung den Ablagerungen (1b) der zweiten Vorrichtung gegenüber liegen, so daß die Gesamtanordnung mit ihren zwei dünnen Schichten senkrecht zur Richtung des Wärmestroms oder des Temperaturgefälles angeordnet ist und der Wärmestrom oder das Temperaturgefälle inder einen Vorrichtung jede Ablagerung nach der dünnen Schicht und in der anderen Vorrichtung vor der dünnen Schicht durchdringt, sowie durch Blöcke (4) aus einem wärmeleitenden Werkstoff, in gleicher Anzahl wie die Ablagerungen einer jeden Vorrichtung, wobei jeder Block mit seiner einen Seite eine Ablagerung (1a) einer ersten Vorrichtung und mit seiner anderen Seite die gegenüberliegende Ablagerung der zweiten Vorrichtung berührt und die Ausdehnung eines Blocks in Längsrichtung des Bandes geringer ist als die Ausdehnung der beiden gegenüberliegenden Ablagerungen, die er berührt, und zwar in der Weise, daß er immer in Längsrichtung der Bänder der beiden Vorrichtungen auf der gleichen Seite der beiden Ablagerungen einen Teil einer jeden Ablagerung (1a, 1b) nicht berührt.

## Claims

1. A device sensitive to heat flow or temperature gradient comprising a first and a second conductor or semi-conductor material having differing thermoelectric properties, the first material consisting of a thin continuous layer in the form of an elongated substantially flat band attached to the surface of a support made of insulation material, the second material consisting of a series of separate zones formed by electrolytic depositions, in a layer thinner than that of the flat band, said depositions being attached to the successive zones of the thin layer along the length of the band on the face thereof which is not attached to the surface of the insulation material, the said device further comprising means whereby to impart a dissymetrical layout to each of said depositions in the lengthwise direction of the band, the dissymetry always following the same direction, said dissymmetry leading to a difference in temperature between the two ends of said band when the said layer is placed substantially perpendicularly to the direction of a heat flow or a temperature gradient (F), so that an electromotive force is generated when said thin layer is placed substantially perpendicular to the direction of said heat flow or said temperature gradient (F).

2. Device according to claim 1, wherein said means to impart dissymetry comprise a series of resin layers (3d) each of these layers covering a part (14d) of each of said depositions and a part (14e) of a portion of the adjacent thin layer not covered by a deposition (Figure 5).

3. Device according to claim 2, wherein each deposition (1e) is in the form of a rectangle arranged transversely to the length of the band and each resin zone (3d) is also in the form of a rectangle arranged transversely to the said direction along the band, each resin zone being arranged partly on a deposition of the second material and partly on the adjacent thin layer not covered by a deposition (Figure 5).

4. Device according to claim 1, wherein, in order to provide said means to impart dissymetry, each deposition of the second material is in a dissymetrical form in the lengthwise direction of the band (Figure 4).

5. Device according to claim 4, wherein each deposition of the second material (1d) comprises a substantially rectangular portion arranged transversely to the lengthwise direction of the band and a trailing portion (1j) pointing in the lengthwise direction of the band, always in the same direction (Figure 4).

6. Device according to any one of the preceding claims, wherein the substantially flat elongated band is in the form of a continuous serpentine band (2c).

7. Device according to any one of the preceding claims, wherein the first material is an alloy known as constantan, while the second material is a conductive metal selected from the group comprising copper and silver.

8. An assembly sensitive to a heat flow or a temperature gradient, comprising a pair of devices according to any one of the preceding claims, the thin layer of the first device being connected electrically in series with the thin layer of the second device, the two devices comprising the same number of depositions of the second material, the two devices of the pair being arranged face to face with the depositions (1a) of the first device opposite the depositions (1b) of the second device so that when the said assembly is placed with its two thin layers substantially perpendicular to the direction of heat flow or temperature gradient, the said heat flow or temperature gradient crosses each deposition of the one device subsequently to crossing its thin layer and, for the other device, prior to crossing its thin layer, and further comprises an assembly of blocks (4) of heat-conductive material, equal in number to that of the depositions of each device, each block being in contact on one of its faces with a deposition (1a) of the first device and on the opposite face with the opposite deposition (1b) of the second device and having a dimension in the lengthwise direction of the band of each device less than the dimension in the same direction of the two depositions arranged face to face, with which it is in contact, so as always to leave a portion (1g, 1h) of a same first side for the first device and of a same second side, confronting the first side, for the second device, in the lengthwise direction of the bands of the two devices, said portion (1g, 1h) of each deposition (1a, 1b) not being in contact with said block (Figure 2).

Fig.1.

Fig.2.

Fig.3.

0 030 499

# Fig.4.

# Fig.5.